# EUROPEAN PATENT APPLICATION

(11) **EP 4 808 288 A1**
(43) Date of publication of application: **16.09.2026**
(21) Application number: 25163452.3
(22) Date of filing: 13.03.2025
(51) Int. Cl.: H05K 1/02, H05K 3/10, H05K 3/16, H05K 3/18, H05K 3/24

(54) **COMPONENT CARRIER WITH STACKED ELECTRICALLY CONDUCTIVE LAYERS, EMBEDDED AND ON THE SURFACE**

(71) Applicant: AT & S Austria Technologie & Systemtechnik Aktiengesellschaft, 8700 Leoben (AT)
(72) Inventor: TAKAHASHI, Hiroaki, 1090 Wien (AT); EBNER, Claudia, 8583 Edelschrott (AT); PALLER, Stefanie, 8020 Graz (AT); SCHULZ, Gernot, 8020 Graz (AT)
(74) Representative: Dilg, Haeusler, Schindelmann Patentanwaltsgesellschaft mbH

(57) **Abstract**

There is described a component carrier (100), comprising:
i) a stack (101), comprising a plurality of electrically conductive layer structures (104) and at least one electrically insulating layer structure (102);
ii) at least one embedded electrically conductive layer structure (110), embedded in the at least one electrically insulating layer structure (102), and exposed at one main surface (103) of the at least one electrically insulating layer structure (102), wherein the at least one embedded electrically conductive layer structure (110) comprises a first amount of stacked electrically conductive layer structures; and
iii) at least one surface electrically conductive layer structure (120), provided on the main surface (103) of the at least one electrically insulating layer structure (102), wherein the at least one surface electrically conductive layer structure (120) comprises a second amount of stacked electrically conductive layer structures.

## Description

### Field of the Invention

The invention relates to a component carrier having a stack, comprising a plurality of electrically conductive layer structures and at least one electrically insulating layer structure, at least one embedded electrically conductive layer structure, embedded in the at least one electrically insulating layer structure, and exposed at one main surface of the at least one electrically insulating layer structure, wherein the at least one embedded electrically conductive layer structure comprises a first amount of stacked electrically conductive layer structures, and at least one surface electrically conductive layer structure, provided on the main surface of the at least one electrically insulating layer structure, wherein the at least one surface electrically conductive layer structure comprises a second amount of stacked electrically conductive layer structures. Further, the invention relates to a method of manufacturing such a component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions.

In particular, forming an efficient and robust component carrier, specifically with respect to signal transmission performance and power/thermal management, may still be considered a challenge.

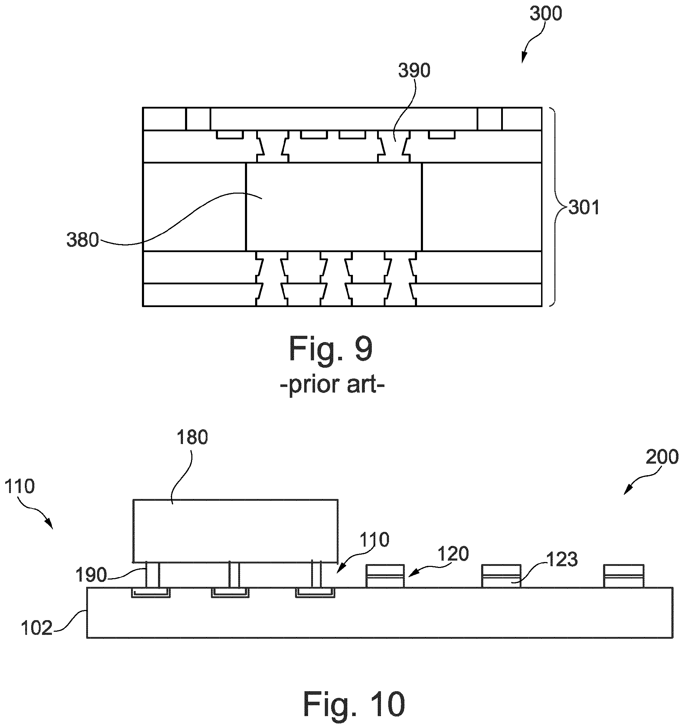

Conventionally, as shown in **Figure 9****,** a component 380 is embedded in a core layer of a stack 301 and electrically contacted from above and below by means of vias 390. The vias 390 are hereby blind vias respectively arranged between a pad of the embedded component 380 and an electrically conductive structure (trench) of the stack 301. Since these blind vias are generally drilled through the layers of the stack 301 by laser drilling, these blind vias 390 have a characteristic tapering shape caused by the laser drilling process.

### Summary of the Invention

There may be a need to provide an efficient and reliable component carrier. According to an exemplary embodiment of the invention, a component carrier, a package, and a method are described.

According to an aspect of the invention, there is described a component carrier comprising:
i) a (multi-layer) stack, wherein the stack comprises: a plurality of electrically conductive layer structures and at least one electrically insulating layer structure (e.g. a resin layer, a core layer, an ABF layer, etc.),
ii) at least one embedded electrically conductive layer structure, embedded in the at least one electrically insulating layer structure, and exposed at one main surface of the at least one electrically insulating layer structure, wherein the at least one embedded electrically conductive layer structure comprises a first amount (a number, for example two) of stacked electrically conductive layer structures, and
iii) at least one surface electrically conductive layer structure, provided on the main surface of the at least one electrically insulating layer structure, wherein the at least one surface electrically conductive layer structure comprises a second amount (for example three) of stacked electrically conductive layer structures.

According to a further aspect of the invention, there is described a package, comprising: a component carrier as described above, and a component, in particular embedded in and/or surface-mounted to the stack.

According to a further aspect of the invention, there is described a method of manufacturing a component carrier, the method comprising:
i) providing/forming a stack, comprising a plurality of electrically conductive layer structures and at least one electrically insulating layer structure,
ii) providing/forming at least one embedded electrically conductive layer structure in the at least one electrically insulating layer structure, so that the at least one embedded electrically conductive layer structure is exposed at one main surface of the at least one electrically insulating layer structure, wherein the at least one embedded electrically conductive layer structure comprises a first amount of stacked electrically conductive layer structures, and iii) providing/forming at least one surface electrically conductive layer structure on the main surface of the at least one electrically insulating layer structure, wherein the at least one surface electrically conductive layer structure comprises a second amount of stacked electrically conductive layer structures.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present document, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive layer structures and at least one electrically insulating layer structure.

In the context of the present document, the term "layer structure" may particularly denote a continuous layer, a patterned layer or a plurality of nonconsecutive islands (discontinuous) within a common plane, and it may perform the function of electrical conductivity and/or electrical insulation. A layer structure may also comprise an interconnection structure which protrudes from a planar surface of the layer structure.

In the context of the present document, the term "embedded electrically conductive layer structure" may in particular refer to an electrically conductive layer structure that is at least partially (in particular fully) embedded in an electrically insulating layer structure. In an embodiment, an embedded electrically conductive layer structure is embedded in the main surface of the electrically insulating layer structure, in particular in a cavity in the main surface of the electrically insulating layer structure, in particular in a cavity exposing at the main surface of the electrically insulating layer structure. The size of an embedded electrically conductive layer structure may thus be defined by the size of the respective cavity. In an embodiment, the embedded electrically conductive layer structure is encapsulated (delimited) at the sidewalls and at the bottom (lower main surface) by material of the electrically insulating layer structure. In an embodiment, the upper main surface of the embedded electrically conductive layer structure is (essentially) flush with the main surface of the electrically insulating layer structure. In the component carrier, the embedded electrically conductive layer structure may be covered by a surface finish and/or solder resist. Alternatively, the embedded electrically conductive layer structure may be buried in the component carrier, e.g. covered by one or more further electrically insulating layer structure(s). In an embodiment, the embedded electrically conductive layer structure is configured as a signal trace, in other words: optimized for signal transduction. For this reason, the embedded electrically conductive layer structure may comprise a low surface roughness and/or a high density/fine line pattern.

In the context of the present document, the term "surface electrically conductive layer structure" may in particular refer to an electrically conductive layer structure that is at least partially (in particular fully) provided/formed on an electrically insulating layer structure. In an embodiment, a surface electrically conductive layer structure is provided/formed on the main surface of the electrically insulating layer structure. In an embodiment, the lower main surface of the surface electrically conductive layer structure is (essentially) flush with the main surface of the electrically insulating layer structure. In an embodiment, the lower main surface of the surface electrically conductive layer structure is provided/formed on the main surface of the electrically insulating layer structure where the embedded electrically conductive layer structure is embedded. In the component carrier, the surface electrically conductive layer structure may be covered (at the sidewalls and/or the exposed main surface) by a surface finish and/or solder resist. Alternatively, the surface electrically conductive layer structure may be buried in the component carrier, e.g. embedded/encapsulated by one or more further electrically insulating layer structure(s). The surface electrically conductive layer structure may be configured for at least one of thermal transport (thermal trace, heat spread), power supply (electric current, high voltage), shielding. In a further embodiment, the surface electrically conductive layer structure may be optimized for the transport of heat/higher currents, while the embedded electrically conductive layer structure may be rather configured for (high performance) signal transmission. The surface electrically conductive layer structure may hence have a rougher surface and/or a lower density (less fine line pattern) in comparison to the embedded electrically conductive layer structure.

In an embodiment, the surface electrically conductive layer structures can be used for increasing the adhesion towards other dielectric layers. Depending on the opening process (e.g. laser, RIE, etc.) the surface roughening of the embedded electrically conductive layer structures can be significantly reduced as compared to the surface electrically conductive layer structures. If the embedded electrically conductive layer structures are used as signal electrically conductive layer structures an increased surface roughness would degrade the signal.

However, smooth surfaces are prone to delaminate. By implementing rough surface electrically conductive layer structures (not used for RF signals) the overall reliability in terms of adhesion is improved (as surface electrically conductive layer structures provide adhesion and embedded electrically conductive layer structures signal performance). Yet, in an embodiment, the surface roughness of both embedded electrically conductive layer structures and surface electrically conductive layer structures can be tuned.

In the context of the present document, the term "stacked electrically conductive layer structure" may in particular refer to a two or more electrically conductive layer structure stacked (vertically) on top of each other, thereby forming the surface electrically conductive layer structure and/or the embedded electrically conductive layer structure. In a preferred embodiment, the surface electrically conductive layer structure and the embedded electrically conductive layer structure comprise some comparable/similar stacked electrically conductive layer structures, e.g. formed in the same process (step). For example, both electrically conductive layer structures, embedded and surface, may comprise a thin first layer that results from a seed layer of the manufacture process. In a further example, both electrically conductive layer structures, embedded and surface, may comprise a thick second layer that results from a common plating process in the manufacture process.

Yet, in another embodiment, the surface electrically conductive layer structure and the embedded electrically conductive layer structure may also comprise different stacked electrically conductive layer structures, in particular with respect to the amount of stacked electrically conductive layer structures. In an embodiment, the surface electrically conductive layer structure comprises an additional base layer that the embedded electrically conductive layer structure may lack.

According to an exemplary embodiment, the invention may be based on the idea that an efficient and reliable component carrier can be provided, when a surface electrically conductive layer structure is formed on a main surface and an embedded electrically conductive layer structure is formed in said main surface of an electrically insulating layer structure, wherein the surface electrically conductive layer structures and the embedded electrically conductive layer structures respectively comprise an amount of stacked electrically conductive layer structures. In this manner, at least two kinds of different electrically conductive layer structures (e.g. traces), in particular with different functionalities, can be provided in the component carrier. The stacked electrically conductive layer structures may reflect common process steps that can provide the electrically conductive layer structures in a highly efficient manner; yet a different amount of stacked electrically conductive layer structures can show that the manufacture processes are not completely similar, thereby providing specific properties to each kind of electrically conductive layer structure.

For example, embedded electrically conductive layer structures may be well protected (also against delamination) and thus provided as fine-line structures, optimized for high performance signal transmission. In a further example, surface electrically conductive layer structures may be less dense but more robust/massive, thereby optimized for the transmission of heat and/or high currents (power supply). Such an architecture may enable a high quality signal transmission and high performance thermal management at the same time in a component carrier.

Said component carrier may be miniaturized and provided as a light-weight and thin product (core or core-less) with a high-performance, e.g. suitable for applications such as implementing an RF-frontend.

### Exemplary Embodiments

In an embodiment, the first amount of stacked electrically conductive layer structures is smaller than the second amount of stacked electrically conductive layer structures. For example, the second amount can comprise one (or more) stacked electrically conductive layer structure more than the first amount. In an embodiment, the first amount can comprise two stacked electrically conductive layer structures and the second amount can comprise three stacked electrically conductive layer structures. This may provide the advantage that different functionalities can be provided for the different electrically conductive layer structures, e.g. by specifically forming the amount of stacked layers defining the required thickness of the surface electrically conductive layer structure and also the required width being provided on the surface (and not in a cavity) of the respective main surface of the electrically insulating layer structure. For example, a higher amount of stacked electrically conductive layer structures may result in a more robust/massive structure, while a lower amount of stacked electrically conductive layer structures may provide a higher density and/or finer pattern. Some stacked electrically conductive layer structures may be formed in the same process and additional stacked electrically conductive layer structures may reflect additional process steps for optimizing the electrically conductive layer structure shape, cross section, functionality.

In an embodiment, the at least one embedded electrically conductive layer structure and the at least one surface electrically conductive layer structure each comprises a first layer, in particular a thin layer. In an embodiment, the first layers are (essentially) similar (in at least one property). In an embodiment, the at least one embedded electrically conductive layer structure and the at least one surface electrically conductive layer structure each comprises a second layer, in particular a thick layer. In an embodiment, the second layers are (essentially) similar (in at least one property). The terms "thin" and "thick" may be seen in this context as relative terms; in other words: the thin layer is thinner than the thick layer and the thick layer is thicker than the thin layer. This may provide the advantage that at least some layers of the embedded electrically conductive layer structure and the surface electrically conductive layer structure are formed in a common process step, e.g. a common seed layer and/or a common plated layer.

In an embodiment, the first layer structure is a seed layer. For example, a seed layer may be formed by a sputtering process, e.g. using PVD or CVD. Often a Ti-Cu layer is provided as a seed layer. This may provide the advantage that a seed layer (recognizable in a final product) from the manufacture process can form part of (both) electrically conductive layer structures as the layer allowing the formation of the subsequent conductive / plated layer / foil.

In an embodiment, the second layer structure is at least one of a plated layer, a conductive foil, a rolled conductive layer. Thereby, established and reliable PCB manufacture process may be directly applied, e.g. onto the seed layer. An electrically conductive foil or a rolled electrically conductive layer may be differentiated from a plated layer structure by the respective internal structure (i.e. different grain shape, for example that of the rolled layer being "squeezed-elongated" in a planar direction, differently from a randomly distributed shape of grains of a plated layer).

In an embodiment, the first layers of the at least one embedded electrically conductive layer structure and the at least one surface electrically conductive layer structure and/or the second layers of the at least one embedded electrically conductive layer structure and the at least one surface electrically conductive layer structure are formed in/with at least one of: the same process step, the same process, the same material, substantially the same thickness, the same internal structure, the same grain size, the same, in particular vertical, order between the respective two layers. In an embodiment, the embedded electrically conductive layer structure and the surface electrically conductive layer structure are partially similar (with respect to at least one property). This may provide the advantage of a highly efficient manufacture process, wherein stacked electrically conductive layer structures for both embedded electrically conductive layer structure and surface electrically conductive layer structure can be formed simultaneously.

In an embodiment, the first layer of the at least one embedded electrically conductive layer structure is arranged between the at least one electrically insulating layer structure and the second layer. For example, the first layer may serve as a seed layer for the subsequent formation of the second layer. For example, the seed layer may be directly formed at a cavity bottom and/or on the main surface of the electrically insulating layer structure. This may provide the advantage that further/second/external layers can be formed in a flexible manner.

In an embodiment, the at least one surface electrically conductive layer structure comprises a base layer. In an embodiment, the base layer is arranged between the at least one electrically insulating layer structure, in particular the main surface, and the other layers of the at least one surface electrically conductive layer structure. This may provide the advantage that the properties (in particular weight and/or thickness; shape) of the (surface) electrically conductive layer structure can be efficiently adjusted. For example, the height/thickness of the base layer may be adjusted to a desired value. In a preferred embodiment, the base layer may be formed from a metal mask (a patterned metal layer) of the manufacture process. Such a metal mask may be used for example during cavity formation. Depending on how the metal mask is provided/formed, the later-on formed base layer can be already tuned. In a further embodiment, the base layer is arranged between the first layer and the second layer.

In an embodiment, the base layer comprises an electrically conductive foil or a rolled electrically conductive layer. This may provide the advantage that the base layer can be formed directly on the main surface of the electrically insulating layer structure, preferably without the need of a seed layer. An electrically conductive foil or a rolled electrically conductive layer may be differentiated from a plated layer structure by the respective internal structure (i.e. different grain shape, for example that of the rolled layer being "squeezed- elongated" in a planar direction, differently from a randomly distributed shape of grains of a plated layer).

In an embodiment, the first layer, in particular the seed layer, of the at least one surface electrically conductive layer structure is arranged between the base layer and the second layer. This may provide the advantage that the base layer may be used as an adjustable and flexible base (without a seed layer), serving as a support for further process steps that may then use a seed layer (e.g. plating). In a further embodiment, the base layer is arranged between the seed layer and the plated layer. In this embodiment, the base layer can also be a plated layer.

In an embodiment, the internal structure of the base layer is different from the internal structure of the second/external layer (for example physical/chemical properties). In an embodiment, the difference refers to at least one of: the layer formation process, the grain size, the (plating) process parameters. In other words: the base layer can be distinguished from the second layer (that may be the external layer). For example, the base layer and the second layer may be formed by different processes (e.g. copper plating and rolled copper), thereby having different grain shapes/sizes (see above), depending of the needed structure and/or dimension (thickness) of each layer.

In an embodiment, the component carrier further comprises a cavity formed in the at least one electrically insulating layer structure, in particular in the main surface, in particular exposed at the main surface. In an embodiment, the at least one embedded electrically conductive layer structure is arranged at least partially in said cavity. This may provide the advantage that the embedding can be done efficiently using established and reliable PCB manufacture process steps and/or that the at least one embedded electrically conductive layer structure is protected, at least at three of the four sides along the longitudinal cross section, by the material of the at least one electrically insulating layer structure. For example, the cavity formation may be done in a straightforward manner using drilling (mechanical and/or laser), cutting, routing, or (wet/plasma) etching. In an embodiment, a reactive ion etching (RIE) process may be used to precisely form the cavity. When forming the cavity, areas not included may be protected by a metal mask or a patterning layer structure.

In an example, a RIE process may comprise the following steps: i) plasma generation: an electromagnetic field ionizes the gas atoms; ii) ion bombardment: ions are accelerated to the substrate, and strike the surface perpendicularly, removing material through physical impact; iii) chemical reactions: reactive radicals in the plasma chemically interact with the surface material, forming volatile byproducts (chemical impact); iv) anisotropic etching: the combination of directional ion bombardment and localized chemical reactions enables highly anisotropic etching, meaning material is removed predominantly in the vertical direction with minimal lateral etching.

In an embodiment, the cavity comprises a rough bottom surface, in particular in the range 0.05 µm to 10 µm. In an embodiment, the roughness of the bottom surface is greater than the roughness of the lateral walls of the cavity. In an embodiment, the roughness is compensated by filling, in particular by a seed layer and/or plating, the cavity. Such a rough surface (in particular at the bottom) may reflect a specific manufacture process, e.g. RIE. Further, a rough surface may improve adhesion to electrically insulating material.

In an embodiment, the first layer, in particular the seed layer, in the cavity comprises two different roughnesses, in particular with respect to the two opposed surfaces of the first layer. In an embodiment, the roughness of the first layer, in particular the seed layer, in the cavity is different, in particular higher, at the bottom side than at the top side (thereby eventually improving the adhesion to the cavity bottom). This structural feature may reflect a specific manufacture process (see above). Advantageously, the seed layer may compensate the rough surface by providing a smooth upper main surface. Thereby, further process steps like plating may be facilitated.

In an embodiment, the surface roughness of the at least one surface electrically conductive layer structure is different, in particular higher, than the surface roughness of the at least one embedded electrically conductive layer structure. This may provide the advantage that signal transmission quality in the embedded electrically conductive layer structure is improved (due to smooth surfaces). In an embodiment, the surface electrically conductive layer structure may optimized for other functionalities than signal transmission quality, thereby making a rough surface acceptable and avoiding further efforts to provide a smooth surface for these electrically conductive layer structures.

In an embodiment, the at least one surface electrically conductive layer structure comprises at least two different vertical extensions and/or a non-constant lateral wall. In an embodiment, the surface electrically conductive layer structure comprises a different non-constant lateral wall and/or at least one of: an inclination, a concave shape a rounded part, a linear part, a fuzzy extension. Such a specific shape may reflect a specific manufacture process, in particular for the patterning of the at least one surface electrically conductive layer structure e.g. by an under-etch (leading to a concave shape in the center, along the vertical extension). In an embodiment, the adhesion may be improved with respect to other layer structures in contact with the at least one surface electrically conductive layer structure by a structure like an under-cut/etch (anchor effect). For minimizing the risk of delamination, especially smooth surfaces may be provided with an under- etch, which could act as an anchor to improve reliability.

In an embodiment, the at least one embedded electrically conductive layer structure and the at least one surface electrically conductive layer structure are provided at least partially in an alternating manner, in particular when seen in a cross-sectional view and/or a planar view. This may provide the advantage that different properties/functionalities may be provided along the component carrier, thereby increasing efficiency and/or functional and/or design flexibility.

In an embodiment, the component carrier further comprises a plurality of embedded electrically conductive layer structures beside each other, in particular having at least a portion being oriented in parallel. In an embodiment, at least one surface electrically conductive layer structure is provided beside said plurality of embedded electrically conductive layer structures, in particular with at least one portion being oriented in parallel with at least one of said plurality of embedded electrically conductive layer structures. In an embodiment, a plurality of surface electrically conductive layer structures are beside each other, with at least one embedded electrically conductive layer structure beside the plurality of surface electrically conductive layer structures. This may provide the advantage of grouping of electrically conductive layer structures, preferably having a common functionality, one beside the other, increasing efficiency and/or functional and/or design flexibility.

In an embodiment, the component carrier further comprises a plurality of embedded electrically conductive layer structures separated by a specific line-spacing, in particular 250 µm or lower, more in particular 100 µm or lower, more in particular 40 µm or lower, more in particular 20 µm or lower, more in particular 10 µm or lower. This may provide the advantage of a high-density structure with a fine-line pattern, so that space can be saved (miniaturization), while the signal transmission quality may be high, in particular with cavity(ies) formation processes resulting in fine dimensions.

In an embodiment, the embedded electrically conductive layer structure is configured for a first functionality, in particular signal transmission. In an embodiment, the surface electrically conductive layer structure is configured for a second functionality, in particular at least one of power transmission (high-voltage/(high) current transmission), thermal transmission, shielding. In an embodiment, the first functionality is different from the second functionality. This may provide the advantage that the embedded electrically conductive layer structure and the surface electrically conductive layer structure may be optimized/configured for different purposes, each with its own strength/advantages.

For example, the embedded electrically conductive layer structure may be well protected and may hence be formed with a very fine line pattern. Such an embedded electrically conductive layer structure may be configured as a signal electrically conductive layer structure for signal transmission, in particular with smooth surfaces. In a further example, the surface electrically conductive layer structure may be exposed and hence configured as a more robust and massive structure. This property may also supply harsher operation conditions such as high currents and/or high temperatures.

In an embodiment, the aspect ratio, in particular height to width ratio, of the at least one embedded electrically conductive layer structure is equal or greater than the respective aspect ratio of the at least one surface electrically conductive layer structure. In an embodiment, the embedded electrically conductive layer structure (embedded electrically conductive layer structure) are fine lines, whereas the surface electrically conductive layer structure (surface electrically conductive layer structure) are usual electrically conductive layer structures. The difference in the aspect ratio may reflect the different kinds of the manufacturing process steps and the consequent functionalities for which electrically conductive layer structures are suitable. In an example, the aspect ratio of the embedded electrically conductive layer structure can be 1:1 or 1 > 1.

In an embodiment, the embedded electrically conductive layer structure is fully embedded, so that only the upper (main) surface is exposed, in particular flush with the main surface of the electrically insulating layer structure. In other words, the lower main surface and the lateral walls may be embedded in insulating material while only the upper main surface is exposed. This may provide the advantage of a robust protection, in particular against delamination. The exposed upper main surface may be protected by a surface finish and/or solder resist. Further, the exposed upper main surface may be covered by a further electrically insulating layer structure and/or electrically connected to a component.

In an embodiment, the first layer comprises sputtered Ti/Cu and/or Cu/Mo. Titanium (or molybdenum) may act as an adhesion layer; titanium bonds strongly with a wide variety of substrates (e.g., silicon, resin, glass, ceramics) and may provide a stable foundation for subsequent layers. Copper is known for its excellent electrical and thermal conductivity. Copper is often deposited on top of titanium to serve as a conductive layer in addition to the adhesive property of titanium.

In an embodiment, the base layer comprises metal, in particular copper, from a metal mask (of the manufacture process) (or a seed layer or an RCC (resin coated copper foil)). In an embodiment, the second layer comprises plated metal, in particular copper. In an embodiment, the electrically insulating layer structure comprises a resin material, in particular a fiber-free material, in particular a reinforced fiber-free material (e.g. reinforced with components such as spheres; an example may be ABF). Thus, established and reliable materials/processes from the PCB manufacture may be applied in a straightforward manner.

In an embodiment, at least one of a height, thickness, an area, a volume of the embedded electrically conductive layer structure is different, in particular smaller, than of the surface electrically conductive layer structure. In an embodiment, the surface electrically conductive layer structure may be larger/thicker, wider than the embedded electrically conductive layer structure. Specifically, the surface electrically conductive layer structure may be more massive/compact than the embedded electrically conductive layer structure. This difference may be provided on purpose to support different functionalities/specializations of said layers.

In an embodiment of the package, an electrically conductive portion of the, in particular embedded, component is in, in particular direct, contact with the at least one embedded electrically conductive layer structure. In an embodiment of the package, the component is arranged on at least one embedded electrically conductive layer structure. For example, the component may be electrically connected (through a terminal/pad) (or through a further electrically conductive connection) with the embedded electrically conductive layer structure, in particular serving as a signal electrically conductive layer structure. This may provide the advantage that a component may be coupled to fine line structure and /or to an efficient signal transmission.

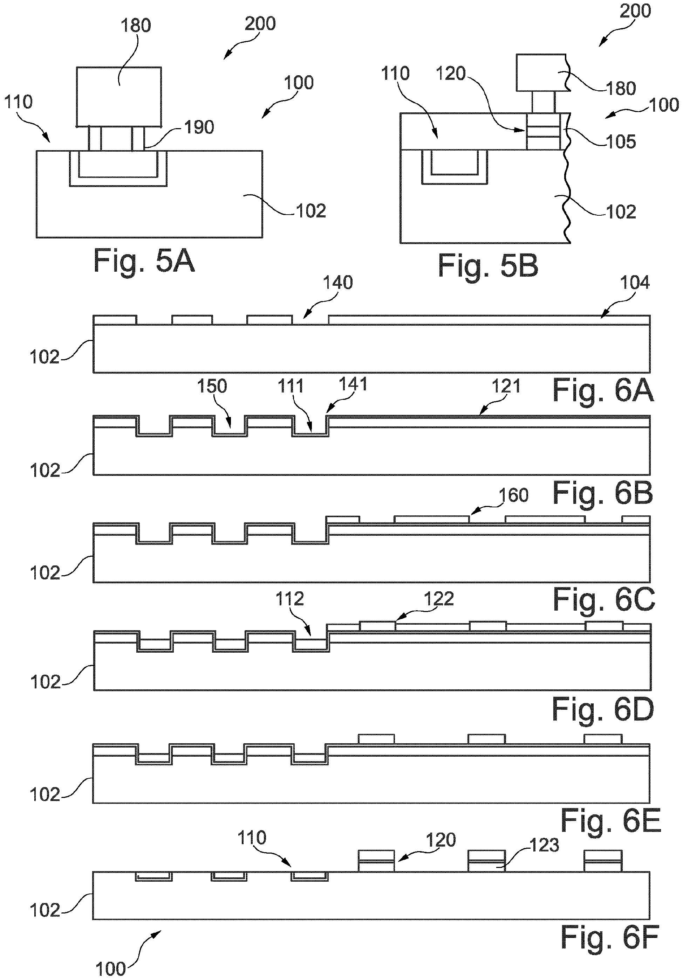

In an embodiment of the package, the component and/or a vertical connection (e.g. a via or a pillar or a solder structure) (see e.g. Figures 5A, 5B, and Figure 10) connecting said component with said at least one embedded electrically conductive layer structure vertically overlaps the at least one surface electrically conductive layer structure. In an embodiment of the package, the component is arranged in the vertical direction on at least one surface electrically conductive layer structure. In an embodiment of the package, the at least one surface electrically conductive layer structure is embedded in a further electrically insulating layer structure. In an embodiment of the package, the component is arranged on the further electrically insulating layer structure and/or the surface electrically conductive layer structure. For example, the component may be electrically connected (through a terminal/pad) (or through a further electrically conductive connection) with the surface electrically conductive layer structure, in particular serving as a power/thermal electrically conductive layer structure. In particular, when the surface electrically conductive layer structure is used as a power supply, a direct physical contact to the component is preferred (I/O comprises power connections and signal connections). This may provide the advantage that a component may be coupled to an efficient power and/or thermal and/or shielding management.

In an embodiment, the component and/or a vertical connection connecting said component with said at least one embedded electrically conductive layer structure vertically overlaps the at least one surface electrically conductive layer structure. This embodiment may be based on the fact that the component assembled on the embedded electrically conductive layer structure, the solder material and/or the component overlaps with the vertical extension (thickness) of the surface electrically conductive layer structures.

In an embodiment, the method comprises: forming a base layer on the at least one electrically insulating layer structure. In an embodiment, the base layer being one of the stacked electrically conductive layer structures of the at least one surface electrically conductive layer structure. In an embodiment, the base layer comprises or consists of the material of a metal layer/mask (in other words: the base layer is formed by patterning the metal layer). This may provide the advantage that the manufacture is more efficient, since the base layer, during its formation process, serves also as a mask, in particular for forming cavities. The metal layer may be provided by plating, rolling or other suitable methods. A patterning may be done by (wet) etching.

In an embodiment, the method further comprises providing a mask layer structure (e.g. a photoresist) as a protection on the base layer for a subsequent cavity formation. Such a mask layer may be used to fill the openings in the mask with material of the second layer, e.g. by plating. Further, such a mask may be used to protect a metal layer/mask during a cavity formation process (e.g. using RIE).

In an embodiment, the method further comprises forming, in particular by etching, more in particular reactive ion etching (RIE), a cavity in the (main surface of the) at least one electrically insulating layer structure. Such a cavity may be formed using efficient and established PCB manufacture steps. A signal electrically conductive layer structure may be well protected, embedded in such a cavity.

In an embodiment, the method further comprises forming a seed layer, in particular by sputtering, on the base layer and/or in the cavity. In an embodiment, the seed layer is subsequently patterned forming the first layer of the stacked electrically conductive layer structures of the at least one embedded electrically conductive layer structure and of the at least one surface electrically conductive layer structure. This may provide the advantage that the first layer of both electrically conductive layer structures is formed in the same process step, i.e. by forming a seed layer. The seed layer may be used for forming a further conductive structure, e.g. the second layer.

In an embodiment, the method further comprises providing the mask layer structure, in particular a photoresist mask, on the base layer, and in particular on the seed layer. This may provide the advantage that a pattern is given to form a further structure, such as the second layer, on top of the seed layer. The seed layer may hereby be continuous, while the second layer is provided as a discontinuous layer in the openings of the mask layer structure.

In an embodiment, the method further comprises filling, in particular plating, the cavity and/or the spaces/openings of the mask layer structure. In an embodiment, to thereby provide a second layer of the stacked electrically conductive layer structures of the at least one embedded electrically conductive layer structure and of the at least one surface electrically conductive layer structure. In this manner, the second layer may be formed efficiently.

In an embodiment, the method further comprises removing the mask layer structure (and/or at least a part of the seed layer) to form the at least one surface electrically conductive layer structure. In a preferred embodiment, removing the mask layer structure and a part of the seed layer may be done in one step, e.g. using RIE.

In an embodiment, the method further comprises adjusting the height of the base layer based on the metal mask. In an embodiment, the method further comprises adjusting the height of the second layer(s) based on the filling, in particular plating, process, and/or the cavity forming. In an embodiment, the embedded electrically conductive layer structure and the surface electrically conductive layer structure are (at least partially) formed simultaneously (through the same process (steps)). This may provide the advantage that a highly efficient and reliable manufacture process can be used, wherein the stacked layers can be actively adapted to desired properties and wherein at least some of the stacked layers can be formed at the same time/process.

In an exemplary embodiment, the thickness of the metal mask used (during the RIE step) can be used to adjust the height (of the surface electrically conductive layer structure). Thereby, a height-defined aspect ratios (AR) below 1:1 can be obtained. The thickness of the at least one embedded electrically conductive layer structure may be defined by the plating process. The height of the mask levels the difference to the required AR. In an exemplary embodiment, the pitch (line-space) defines the widths between the at least one embedded electrically conductive layer structures. The minimum distance between the at least one embedded electrically conductive layer structures may be defined by the occurrence of cross talk.

In an embodiment, when the surface electrically conductive layer structure is plated (and not etched), thick copper electrically conductive layer structures may become expensive and resource-intensive (due to the current and chemicals needed during the plating process). Accordingly, subtractive etching may be preferred for thick electrically conductive layer structures over plating. However, if one needs to plate the surface electrically conducive layer structure, an initially thicker seed layer (metal mask) can significantly shorten the plating process and thereby reduce the amount of resources needed (as the mask in the one process flows stay in the stack as part of the surface electrically conductive layer structure). Thus, by using the metal mask as height leveling mask, one may manufacture the surface electrically conductive layer structures in a more sustainable manner.

In an embodiment, the mask can be metal-based or any patterning layer structure (e.g. polymer-based photoresist). The mask used may depend on the process flow, e.g. if the surface electrically conductive layer structure is obtained by plating, the mask should be metal-based, and if the surface electrically conductive layer structure is obtained by subtractive etching, the mask is most likely a photoresist.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component (in particular the embedded component), which may be surface mounted on and/or embedded in the component carrier, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In an embodiment, the metal of the surface finish is more noble than the metals of the surface/embedded electrically conductive layer structure(s).

The aspects defined above and further aspects of the invention are apparent from the examples of embodiment to be described hereinafter and are explained with reference to these examples of embodiment.

### Brief Description of the Drawings

Figure 1 illustrates a component carrier according to an exemplary embodiment of the invention.
Figure 2 illustrates schematically surface roughnesses of a component carrier, according to an exemplary embodiment of the invention.
Figure 3 illustrates a specific concave shape of a surface electrically conductive layer structure, according to an exemplary embodiment of the invention.
Figure 4A and Figure 4B illustrate an embedded electrically conductive layer structure in a cavity, according to an exemplary embodiment of the invention.
Figure 5A illustrates a component on the embedded electrically conductive layer structure and Figure 5B illustrates a component on the surface electrically conductive layer structure, according to an exemplary embodiment of the invention.
Figure 6A, Figure 6B, Figure 6C, Figure 6D, Figure 6E, and Figure 6F illustrate a process of manufacturing a component carrier, according to an exemplary embodiment of the invention.
Figure 7A, Figure 7B, Figure 7C, Figure 7D, Figure 7E, Figure 7F, Figure 7G, Figure 7H, and Figure 7I illustrate a further process of manufacturing a component carrier, according to a further exemplary embodiment of the invention.
Figure 8 shows a component carrier product, according to an exemplary embodiment of the invention.
Figure 9 shows a conventional circuit board with vias.
Figure 10 shows a component carrier with a surface-mounted component, according to an exemplary embodiment of the invention.

### Detailed Description of the Drawings

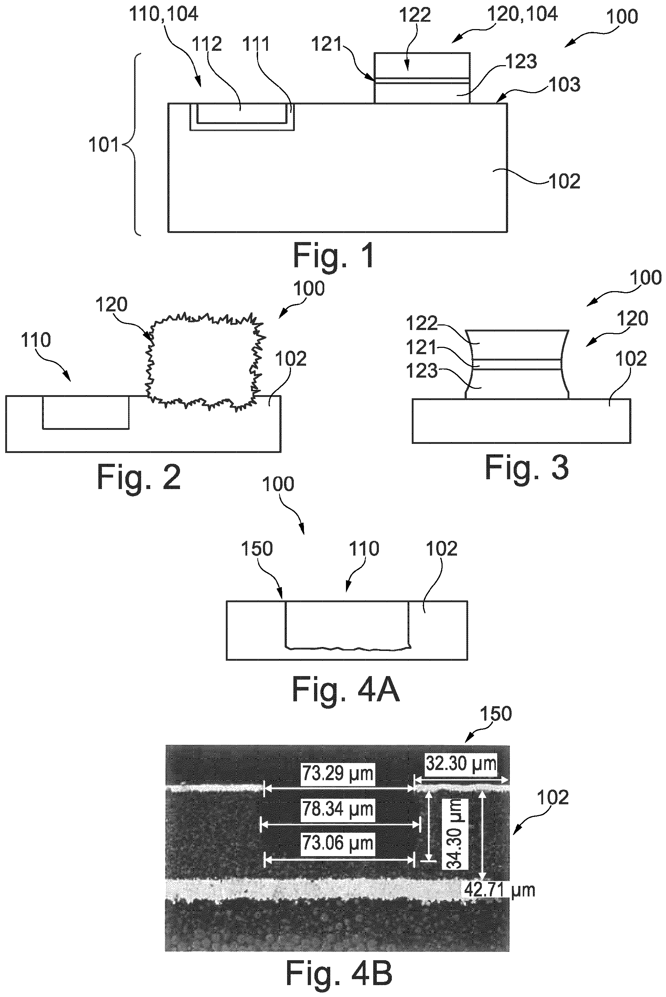

**Figure 1** illustrates a component carrier 100, according to an exemplary embodiment of the invention, having a stack 101 with a plurality of electrically conductive layer structures 104 and an electrically insulating layer structure 102.

An embedded electrically conductive layer structure 110 is embedded in the electrically insulating layer structure 102 and exposed at the upper main surface 103 of the electrically insulating layer structure 102. The embedded electrically conductive layer structure 110 comprises a first amount of stacked electrically conductive layer structures, in this example the first amount is two.

A surface electrically conductive layer structure 120 is provided on the main surface 103 of the electrically insulating layer structure 102, wherein the surface electrically conductive layer structure 120 comprises a second amount of stacked electrically conductive layer structures, in this example the second amount is three, thus the first amount is smaller than the second amount.

Each of the embedded electrically conductive layer structure 110 and the surface electrically conductive layer structure 120 comprises a first layer 111, 121, being a thin layer. The first layer 111, 121 is a seed layer. In an exemplary embodiment, the seed layer comprises Ti/Cu and is manufactured by a sputtering process. The first layer of the embedded electrically conductive layer structure 111 and the first layer of the surface electrically conductive layer structure 121 can be formed in the same manufacture process, for example by sputtering the bottom/sidewalls of a cavity in the electrically insulating layer structure 102 and a base structure 123 on top of the electrically insulating layer structure 102. The embedded electrically conductive layer structures 110 are fully embedded, so that only the upper surface is exposed, being flush with the main surface 103.

Further, each of the embedded electrically conductive layer structure 110 and the surface electrically conductive layer structure 120 comprises a second layer 112, 122 being a thick layer, for example a plated layer (or a conductive foil or a rolled conductive layer). The second layer of the embedded electrically conductive layer structure 112 and the second layer of the surface electrically conductive layer structure 122 can be formed in the same manufacture process, for example by performing a plating process on top of the respective seed layer 111, 121.

In an embodiment, the first layers 111, 121 and the second layers 112, 122 of the embedded electrically conductive layer structure 110 and the surface electrically conductive layer structure 120 are formed with the same process, with the same material, and substantially the same thickness, and the same grain size. The respective first layer 111 is hereby arranged between the electrically insulating layer structure 102 and the second layer 112.

In this example, the surface electrically conductive layer structure 120, in contrast to the embedded electrically conductive layer structure 110, comprises a base layer 123. Said base layer 123 is arranged between the main surface 103 of the electrically insulating layer structure 102 and the other layers 121, 122 of the surface electrically conductive layer structure 120. The first layer 121 of the surface electrically conductive layer structure 120 is arranged between the base layer 123 and the second layer 122. The base layer 123 comprises for example an electrically conductive foil or a rolled electrically conductive layer, arranged on the main surface 103, and serving as a base for subsequent sputtering and plating processes that may provide the first layers 111, 121 and the second layers 112, 122, respectively.

Since the base layer 123 is provided in a different process than the second layer 122, the internal structure of the base layer 123 is different from the internal structure of the second layer 122, e.g. different with respect to the grain size.

**Figure 2** illustrates schematically the surface roughness of a component carrier 100, according to an exemplary embodiment of the invention. There is schematically illustrated the surface roughness of the surface electrically conductive layer structure 120 (being very rough) and the surface roughness of the embedded electrically conductive layer structure 110 (being very smooth), being different form each other. The embedded electrically conductive layer structure 110 is hereby configured for a first functionality, such as signal transmission, where a smooth surface is advantageous, and the surface electrically conductive layer structure 120 is configured for a second functionality, for example at least one of power transmission (high-voltage/current transmission), thermal transmission, shielding, wherein the rough surface may not be an issue. Instead, the rough surface may supply a good adhesion (peel strength) to electrically insulating material.

The embedded electrically conductive layer structures 110 can be formed as fine lines (high density) and have a greater aspect ratio (height to width ratio) than the surface electrically conductive layer structure 120, that can be formed as normal lines (normal/low density). A height/thickness/area/volume of the embedded electrically conductive layer structure 111 is different (here smaller) than of the surface electrically conductive layer structure 120.

**Figure 3** illustrates a specific concave shape of a surface electrically conductive layer structure 120, according to an exemplary embodiment of the invention. The surface electrically conductive layer structure 120 comprises here two different vertical extensions, in other words a non-constant lateral wall. The non-constant (in vertical direction) lateral wall comprises a rounded part in the middle, being a concave shape. The base layer 123 is tapering in the upward direction and the first layer 121 (seed layer) comprises a width much smaller than at the base of the base layer 123. The second layer 122 in turn is widening/broadening again in the upward direction, away from the first layer 121. Such a structure may result from an under-etch during the manufacture process.

Such a structure may be formed e.g. by a process flow using plating as described for Figures 6A to 6F. As the metal mask is used as seed layer, the metal mask between the surface electrically conductive layer structures must be removed. This is done by (flash) etching (process step 6E and 6F). Dependent on the thickness of the metal mask, the under-etch can be more or less pronounced. Thinner metal masks show less under-etch in the final surface electrically conducive layer structure as compared to the thicker metal mask.

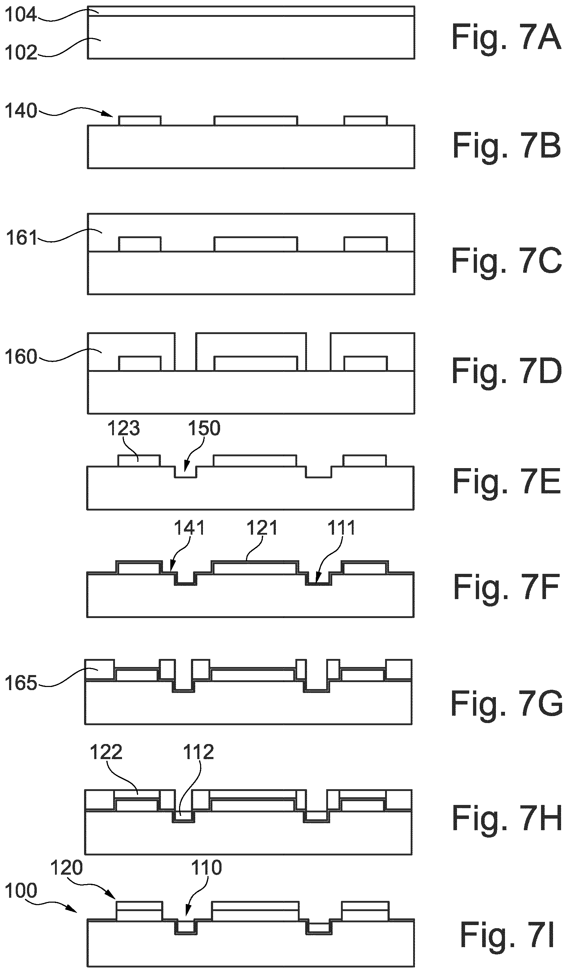

Further, such a structure may be formed e.g. by a process flow using subtractive etching (under-etch may occur naturally due to the etching process), see e.g. Figure 7B.

**Figure 4A and Figure 4B** illustrate an embedded electrically conductive layer structure 110 in a cavity 150, according to an exemplary embodiment of the invention. According to Figure 4A, a cavity 150 is formed in the main surface 103 of the electrically insulating layer structure 102, wherein the embedded electrically conductive layer structure 110 is arranged fully in said cavity 150. It is schematically illustrated that the cavity 150 comprises a rough bottom surface, e.g. in the range 0.05 µm to 10 µm. The roughness of the bottom surface is thereby greater than the roughness of the lateral walls of the cavity 150. It follows that the first layer 111 in the cavity 150 comprises two different roughnesses with respect to the two opposed surfaces of the first layer 111, i.e. the roughness of the first layer 111 in the cavity 150 is higher at the bottom side, than at the top side. Figure 4B shows a cross-section of a microscopic image of the empty cavity 150 with exemplary measures.

**Figure 5A** illustrates a component 180 on the embedded electrically conductive layer structure 110 and **Figure 5B** illustrates a component 180 on the surface electrically conductive layer structure 120, according to an exemplary embodiment of the invention. Figures 5A and 5B refer respectively to a package 200 that comprises a component carrier 100 (as described above) and a component 180 (an active or passive component, e.g. a semiconductor element). In Figures 5A and 5B, a vertical connection 190 such as a pillar (or an electric contact such as a solder ball (BGA ball)) can be arranged between the surface electrically conductive layer structure 120 (here embedded) and (a pad of) the component 180.

**Figure 5A****:** the component 180 is mounted on the main surface 103 of the electrically insulating layer structure 102 and an electrically conductive portion of the component 180 is in contact with the embedded electrically conductive layer structure 110. The component 180 is arranged hereby at least partially on the embedded electrically conductive layer structure 110. Thereby, an electric connection between the component 180 and the embedded electrically conductive layer structure 110 can be provided. In other words, the component 180 can be electrically connected to an electrically conductive layer structure 110. For the electric connection, there are provided vertical connections 190, in this example realized by copper pillars.

**Figure 5B****:** in this example, a further electrically insulating layer structure 105 is formed on top of the electrically insulating layer structure 102, thereby covering the embedded electrically conductive layer structure 110 and embedding/encapsulating the surface electrically conductive layer structure 120. The component 180 is mounted on top of the further electrically insulating layer structure 105 and the surface electrically conductive layer structure 120. Thereby, an electric connection between the component 180 and the surface electrically conductive layer structure 120 can be provided, i.e. for power transmission and/or thermal management. In this example, the electric connection is realized by vertical connections 190.

**Figure 6A, Figure 6B, Figure 6C, Figure 6D, Figure 6E, and Figure 6F** illustrate a process of manufacturing a component carrier 100, according to an exemplary embodiment of the invention.

Figure 6A: an electrically insulating layer structure 102 is provided, for example a fiber-free resin such as ABF. An electrically conductive layer (or an RCC) 104 is formed on top (e.g. a copper layer). The electrically conductive layer 104 is patterned (e.g. by etching) to provide a metal mask 140.

Figure 6B: cavities 150 are formed in the main surface 103 of the electrically insulating layer structure 102 at the openings in the metal mask 140. For forming the cavities 150, a precise ablation process such as RIE (reactive ion etching) is used. The metal mask 140 is hereby used as a protection of non-etched areas. As will be described further below, the metal mask 140 can later-on serve as the base layer 123 of the surface electrically conductive layer structures 120. Thus, the metal mask 140 can be used to adjust the height of the surface electrically conductive layer 120. After the cavity 150 formation, a seed layer 141 (e.g. Ti-Cu or Cu/Mo sputtering) is formed over the exposed surfaces. Said seed layer 141 can later-on serve as the first layer 111, 121. For forming the seed layer 141, a sputtering process (or electro-less process) can be used, e.g. PVD.

Figure 6C: a mask layer structure (a protection structure) 160 is applied to the areas of the later-on surface electrically conductive layer structures 120, and is not applied to the areas of the later-on embedded electrically conductive layer structures 110, where the cavities 150 have been formed. In this example, the mask layer structure 160 is provided as a photoresist.

Figure 6D: electrically conductive material for forming the second layers 112, 122 is provided, preferably by plating (e.g. copper). Hereby, the second layer 112 of the embedded electrically conductive layer structures 110 and the second layer 122 of the surface electrically conductive layer structures 120 are formed at the same time and by the same (plating) process. The second layer 112 of the embedded electrically conductive layer structures 110 is provided by filling (partially or completely) the cavities 150, and the second layer 122 of the surface electrically conductive layer structures 120 is provided by filling the spaces in the mask layer structure 160 (on top of the seed layer 141 and the metal mask 140).

Figure 6E: the mask layer structure 160 is removed (stripped), thereby exposing the second layer 122 of the surface electrically conductive layer structures 120. In an embodiment, the embedded electrically conductive layer structures 110 can be protected by another photoresist (this depends on the height of the metal mask). If very thick metal masks are used to generate a thick surface electrically conductive layer structure, the embedded electrically conductive layer structures 110 should be protected, as the etching step takes longer and would partially remove the embedded electrically conductive layer structures 110.

Figure 6F: the metal mask 140 is partially removed, in particular those parts of the metal mask 140, which are not covered by the second layer 122 of the surface electrically conductive layer structures 120, are removed (the same holds true for the seed layer 141 on top of the metal mask 140). In this manner, a component carrier 100 product as described for Figure 1 can be obtained.

In an exemplary embodiment, the steps of Figures 6E and 6F can be combined, e.g. using a RIE process. Thereby, the mask layer structure 160, the seed layer 141 and the metal mask 140 can be removed in one process step. Alternatively, the step of Figure 6F can be performed using a photomask protecting the later-on surface electrically conductive layer structures 120.

**Figure 7A, Figure 7B, Figure 7C, Figure 7D, Figure 7E, Figure 7F, Figure 7G, Figure 7H, and Figure 7I** illustrate another process of manufacturing a component carrier 100, according to a further exemplary embodiment of the invention.

Figure 7A: an electrically insulating layer structure 102 is provided, for example a fiber-free resin such as ABF. An electrically conductive layer 104 is formed on top (e.g. a copper layer). Alternatively, one can start from a core layer or an RCC.

Figure 7B: the electrically conductive layer is patterned (e.g. by etching) to provide a metal mask 140.

Figure 7C: a mask layer structure preform 161 (e.g. a photoresist; thick resist lamination) is provided/laminated on top of the metal mask 140.

Figure 7D: the mask layer structure preform 161 is patterned to form a mask layer structure 160, covering the metal parts of the metal mask 140.

Figure 7E: at the areas not covered by the mask layer structure 160, cavities 150 are formed. For forming the cavities 150, a precise ablation process such as RIE (reactive ion etching) can be used. As will be described further below, the metal mask 140 can later-on serve as the base layer 123 of the surface electrically conductive layer structures 120. Thus, the metal mask 140 can be used to adjust the height of the surface electrically conductive layer structures 120. The mask layer structure 160 is then removed.

Figure 7F: after the cavity 150 formation and mask removal 160, a seed layer 141 (e.g. Ti-Cu sputtering) is formed over the exposed surfaces. Said seed layer 141 can later-on serve as the first layer 111, 121. For forming the seed layer 141, a sputtering process can be used, e.g. PVD.

Figure 7G: a further mask layer structure 165 is provided at the areas between the metal mask 140 portions (the base layer 123) and the cavities 150. It should be noted that the further mask layer structure 165 is provided higher (thicker) than the metal mask 140 portions. The further mask layer structure 165 can be a photoresist identical or different to the mask layer structure 160.

Figure 7H: electrically conductive material for forming the second layer 112, 122 is provided, preferably by plating (e.g. copper). Hereby, the second layer 112 of the embedded electrically conductive layer structures 110 and the second layer 122 of the surface electrically conductive layer structures 120 are formed at the same time and by the same (plating) process. The second layer 112 of the embedded electrically conductive layer structures 110 is provided by filling (partially or completely) the cavities 150, and the second layer 122 of the surface electrically conductive layer structures 120 is provided by filling the spaces in the further mask layer structure 165 on top of the seed layer 141 and the metal mask 140 portions.

Figure 7I: the further mask layer structure 165 is removed (stripped). In this manner, a component carrier 100 product as described for Figure 1 can be obtained. In an exemplary embodiment, a RIE process can be used to remove the further mask layer structure 165 and the seed layer 141 below in one process step.

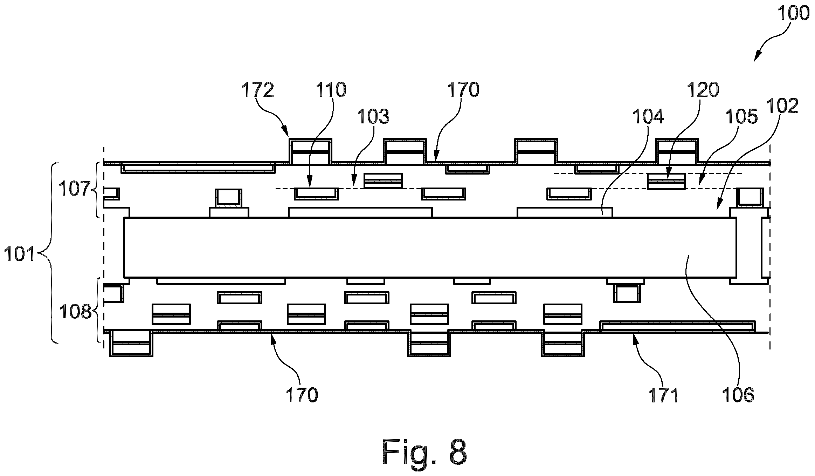

**Figure 8** shows a component carrier 100, according to an exemplary embodiment of the invention, wherein said component carrier 100 can be either a final product or a semi-finished product. It can be seen that the component carrier 100 comprises a central core layer structure 106 (for example a fully cured resin, a metal, a glass core, etc.). A plurality of layer structures are stacked on top of the core layer structure 106, forming an upper build-up structure 107, and a plurality of further layer structures are stacked at the bottom of the core layer structure 106, forming a lower build-up structure 108. Each build-up structure 107, 108 has been formed by stacking a plurality of electrically insulating layer structures 102 and a plurality of electrically conductive layer structures 104, for example by alternating laminating and plating process steps.

Each build-up structure 107, 108 comprises an electrically insulating layer structure 102 with a main surface 103 as described above, wherein the embedded electrically conductive layer structures 110 are embedded in the electrically insulating layer structure 102 (and flush with the main surface 103) and wherein the surface electrically conductive layer structures 120 are surface mounted to said main surface 103. On top of said main surface 103 of the electrically insulating layer structure 102, there is formed a further electrically insulating layer structure 105, embedding the surface electrically conductive layer structures 120, and thereby enabling a further layer build-up.

In a first embodiment, the component carrier 100 is a final product with a central core. In a second embodiment, the component carrier 100 is a semi-finished product of the manufacture process, wherein two coreless component carriers 107, 108 are formed on the opposed main surfaces of the central core layer structure 106. In this example, the core layer structure 106 can serve as a temporary carrier for the manufacture process, and will be removed later-on to provide the coreless component carriers 107, 108.

On top of the respective layer build-ups 107, 108, there is formed a solder resist layer structure 170. Additionally or alternatively, a surface finish can be applied to the embedded electrically conductive layer structures 110 (as a first surface finish 171) and/or to the surface electrically conductive layer structures 120 (as a second surface finish 172). The first surface finish 171 is in this example flush with the main surface of the component carrier 100 (in particular with the solder resist layer structure 170). The second surface finish 172 is in this example covering the sidewalls and the top of the surface mounted surface electrically conductive layer structures 120. In an example, a surface finish comprises more noble metal than the surface/embedded electrically conductive layer structure(s).

It can be seen that the embedded electrically conductive layer structures 110 and the surface electrically conductive layer structures 120 are provided in an alternating manner, when seen in this cross-sectional view (but also in a planar view (in the Z-direction). Yet, the embedded electrically conductive layer structures 110 and the surface electrically conductive layer structures 120 do not need to be alternatingly. Two or more embedded electrically conductive layer structures 110 can be placed next to each other, e.g. followed by surface electrically conductive layer structures 120. Also shown in the figure is a via (formed in the same manner as the surfaces electrically conductive layer structures 120).

The component carrier 100 comprises a plurality of embedded electrically conductive layer structures 110 beside each other (in parallel) and the surface electrically conductive layer structures 120 provided beside said plurality of embedded electrically conductive layer structures 110 (oriented in parallel with said plurality of embedded electrically conductive layer structures 110). The embedded electrically conductive layer structures 110 are separated by a specific line-spacing, for example 250 µm or lower; but can also be significantly lower, e.g. 10 µm or lower.

**Figure 10** shows a component carrier 200 with a surface-mounted component 180, according to an exemplary embodiment of the invention. The component 180 is mounted on the main surface 103 of the electrically insulating layer structure 102 and electrically conductive portions (e.g. pads) of the component 180 are respectively in contact with the embedded electrically conductive layer structures 110. The component 180 is arranged hereby on the embedded electrically conductive layer structures 110. Thereby, an electric connection between the component 180 and the embedded electrically conductive layer structures 110 can be provided. For the electric connection, there are provided vertical connections 190, in this example realized by copper pillars. In this example, each electric connection of the component 180 is connected by one vertical connection 190 to one embedded electrically conductive layer structure 110. The vertical connection structure 190 may be a via, pillar or any solder structure.

### Reference signs

- 100: Component carrier
- 101: Stack
- 102: Electrically insulating layer structure
- 103: Main surface
- 104: Electrically conductive layer structure
- 105: Further electrically insulating layer structure
- 106: Core layer
- 107: Upper build-up structure
- 108: Lower build-up structure
- 110: Embedded electrically conductive layer structure
- 111: First layer of the embedded electrically conductive layer structure
- 112: Second layer of the embedded electrically conductive layer structure
- 120: Surface electrically conductive layer structure
- 121: First layer of the surface electrically conductive layer structure
- 122: Second layer of the surface electrically conductive layer structure
- 123: Base layer
- 140: Metal mask
- 141: Seed layer
- 150: Cavity
- 160: Mask layer structure, photo-resist
- 161: Mask layer structure preform
- 165: Further mask layer structure
- 170: Solder resist layer structure
- 171: First surface finish layer structure
- 172: Second surface finish layer structure
- 180: Component
- 190: Vertical connection
- 200: Package

## Claims

1. A component carrier (100), comprising:
a stack (101), comprising a plurality of electrically conductive layer structures (104) and at least one electrically insulating layer structure (102);
at least one embedded electrically conductive layer structure (110), embedded in the at least one electrically insulating layer structure (102), and exposed at one main surface (103) of the at least one electrically insulating layer structure (102),
wherein the at least one embedded electrically conductive layer structure (110) comprises a first amount of stacked electrically conductive layer structures; and
at least one surface electrically conductive layer structure (120), provided on the main surface (103) of the at least one electrically insulating layer structure (102),
wherein the at least one surface electrically conductive layer structure (120) comprises a second amount of stacked electrically conductive layer structures.

2. The component carrier (100) according to claim 1,
wherein the first amount is smaller than the second amount.

3. The component carrier (100) according to claim 1 or 2,
wherein the at least one embedded electrically conductive layer structure (110) and the at least one surface electrically conductive layer structure (120) each comprises
a first layer (111, 121), in particular a thin layer, and
a second layer (112, 122), in particular a thick layer,
in particular
wherein the first layer structure (111, 121) is a seed layer (141); and/or
wherein the second layer structure (112, 122) is at least one of a plated layer, a conductive foil, a rolled conductive layer.

4. The component carrier (100) according to claim 3,
wherein the at least one surface electrically conductive layer structure (120) comprises a base layer (123), and
wherein the base layer (123) is arranged between the at least one electrically insulating layer structure (102), in particular the main surface (103), and the other layers (121, 122) of the at least one surface electrically conductive layer structure (120).

5. The component carrier (100) according to claim 4,
wherein the internal structure of the base layer (123) is different from the internal structure of the second/external layer (122),
in particular different with respect to at least one of: the layer formation process, the grain size, the process parameters.

6. The component carrier (100) according to one of the preceding claims, further comprising:
a cavity (150) formed in the main surface (103), and
wherein the at least one embedded electrically conductive layer structure (110) is arranged at least partially in said cavity (150).

7. The component carrier (100) according to claim 6,
wherein the cavity (150) comprises a rough bottom surface, in particular in the range 0.05 µm to 10 µm,
in particular the roughness of the bottom surface is greater than the roughness of the lateral walls of the cavity (150).

8. The component carrier (100) according to one of the preceding claims,
wherein the surface roughness of the at least one surface electrically conductive layer structure (120) is different, in particular higher, than the surface roughness of the at least one embedded electrically conductive layer structure (110).

9. The component carrier (100) according to one of the preceding claims,
wherein the at least one surface electrically conductive layer structure (120) comprises at least two different vertical extensions and/or a non-constant lateral wall,
in particular a different non-constant lateral wall and/or at least one of: an inclination, a concave part, a rounded part, a linear part, a fuzzy extension.

10. The component carrier (100) according to one of the preceding claims,
wherein the aspect ratio, in particular height to width ratio, of the at least one embedded electrically conductive layer structure (110) is greater than the respective aspect ratio of the at least one surface electrically conductive layer structure (120).

11. A package (200), comprising:
a component carrier (100) according to one of the preceding claims; and
a component (180), in particular embedded in and/or surface-mounted to the stack (101).

12. The package according to claim 11,
wherein the component (180) is arranged on at least one embedded electrically conductive layer structure (110),
in particular wherein the component (180) and/or a vertical connection (190) connecting said component (180) with said at least one embedded electrically conductive layer structure (110) vertically overlaps the at least one surface electrically conductive layer structure (120).

13. A method of manufacturing a component carrier (100), the method comprising:
providing a stack (101), comprising a plurality of electrically conductive layer structures (104) and at least one electrically insulating layer structure (102);
providing at least one embedded electrically conductive layer structure (110) in the electrically insulating layer structure (102), so that the at least one embedded electrically conductive layer structure (110) is exposed at one main surface (103) of the at least one electrically insulating layer structure (102), wherein the at least one embedded electrically conductive layer structure (110) comprises a first amount of stacked electrically conductive layer structures; and
providing at least one surface electrically conductive layer structure (120) on the main surface (103) of the at least one electrically insulating layer structure (102), wherein the at least one surface electrically conductive layer structure (120) comprises a second amount of stacked electrically conductive layer structures.

14. The method according to claim 13, further comprising:
forming a base layer (123) on the electrically insulating layer structure (102), said base layer (123) being one of the stacked electrically conductive layer structures of the at least one surface electrically conductive layer structure (120),
in particular wherein the base layer (123) comprises or consists of the material of a metal layer (140).

15. The method according to claim 13 or 14, further comprising:
providing a mask layer structure (160) as a protection on the base layer (123) for a subsequent cavity (150) formation;
and/or
forming, in particular by etching, more in particular reactive ion etching, a cavity (150) in the at least one electrically insulating layer structure (102); and/or
forming a seed layer (141), in particular by sputtering, on the base layer (123) and/or in the cavity (150),
in particular wherein the seed layer (141) is subsequently patterned forming the first layer (111, 121) of the stacked electrically conductive layer structures of the at least one embedded electrically conductive layer structure (110) and of the at least one surface electrically conductive layer structure (120);
and/or
providing the mask layer structure (160), in particular a photo-resist mask, on the base layer (123), and in particular on the seed layer (141); and/or
filling, in particular plating, the cavity (150) and/or the spaces of the mask layer structure (160),
in particular to thereby provide a second layer (112, 122) of the stacked electrically conductive layer structures of the at least one embedded electrically conductive layer structure (110) and of the at least one surface electrically conductive layer structure (120);
and/or
removing the mask layer structure (160) and at least a part of the seed layer (141) to form the at least one surface electrically conductive layer structure (120);
and/or
adjusting the height of the base layer (123) based on the metal mask (140);
and/or
adjusting the height of the second layers (112, 122) based on the filling, in particular plating, process, and/or the cavity forming;
and/or
wherein the embedded electrically conductive layer structure (110) and the surface electrically conductive layer structure (120) are formed simultaneously.
